# EUROPEAN PATENT APPLICATION

(11) **EP 4 523 832 A1**
(43) Date of publication of application: **19.03.2025**
(21) Application number: 24151859.6
(22) Date of filing: 15.01.2024
(51) Int. Cl.: B23K 26/03, B23K 26/0622, B23K 26/06, B23K 26/342, B29C 64/273, B29C 64/393, B33Y 10/00, B33Y 30/00, C12N 5/00

(54) **LINE-ILLUMINATION TEMPORAL FOCUSING 3D NANO-FABRICATION APPARATUS AND METHOD**

(30) Priority: 14.09.2023 US 202318467170
(71) Applicant: Centre for Perceptual and Interactive Intelligence (CPII) Limited, Pak Shek Kok, New Territories (HK)
(72) Inventor: CHEN, Shih-Chi, Shatin, New Territories (HK); GU, Songyun, Yuyao, Zhejing (CN); ZHONG, Qiuyuan, Shatin, New Territories (HK)
(74) Representative: Beck & Rössig European Patent Attorneys

(57) **Abstract**

The present invention teaches an apparatus and method for line-illumination temporal focusing three-dimensional (3D) nano-fabrication, the apparatus and method comprising: a laser source (110) configured to emit a laser beam (111); a line-illumination pattern unit (150) forming a pre-determined line pattern from a line-shaped beam; a data acquisition unit (120) receiving input and transmitting output signals for movement synchronization of multiple devices; an optical imaging device (130) configured to monitor fabrication process in real time; a controller unit (140); and a substrate plane (170).

## Description

### FIELD OF THE INVENTION

The present invention relates to a three-dimensional (3D) nano-fabrication apparatus and method, and more particularly to form a three-dimensional object on a target surface based on a line-illumination system. The 3D nanofabrication apparatus and method related to the present invention are applied to perform ultrafast three-dimensional nanofabricating or nano-printing with different projected patterns.

### BACKGROUND OF THE INVENTION

Three-dimensional (3D) nanofabrication is an advanced form of additive manufacturing that involves creating 3D structures and objects at the nanoscale level. It combines principles from traditional 3D fabricating with techniques from nanotechnology to achieve an unprecedented level of precision and resolution. Nanoscale fabrication allows for the creation of intricate structures, devices, and materials with dimensions on the order of nanometres (billionths of a meter).

One of the primary goals of 3D nanofabrication is to achieve extremely high resolution, enabling the fabrication of intricate structures with details and features on the nanometer scale. Different techniques can be used for fabricating at nanoscale, such as two-photon lithography, electron beam lithography, focused ion beam (FIB) milling, and more, while only a few of them can generate true 3D structures directly. These techniques utilize focused beams of energy to manipulate and deposit materials at the nanoscale. Nanofabrication technologies allow for the precise deposition of materials, whether they are polymers, metals, ceramics, or other substances, at the nanoscale.

Temporal focusing (TF) is one of the optical techniques used in 3D nanofabrication systems as it involves manipulating the temporal profile (time duration) of a light pulse while keeping its spatial properties relatively unchanged. It has been proven to provide high-speed sub-micrometer fabrication capability, setting many world records in terms of the throughput, resolution, and material adaptability. However, the original TF fabrication system, i.e., femtosecond projection two-photon lithography (TPL) (described in United States Patent No. 10,207,365 B2 and No. 11,312,067) - a 2D projection technique, requires an complex regenerative femtosecond (fs) laser amplifier of low repetition rate (e.g., 1 kHz) to provide sufficient pulse energy; the high patterning rate is achieved at the expense of complex exposure and laser tuning procedure; for example, its axial feature size and intensity vary with different projected patterns, making structure optimization challenging.

Generally, temporally focusing of a laser can be achieved by (1) stretching the laser pulse in the time domain, and (2) compressing the pulse to increase the peak intensity only at the desired plane. In an original TF setup, i.e., a wide-field TF design, the pulse stretching is realized by a dispersion component, e.g., a diffraction grating or a digital micro-mirror device (DMD). In a DMD-based TF system, a femtosecond (fs) laser is first dispersed by the DMD. As different spectral components of the fs laser travel through different distances in space, the phases for different spectral components are mismatched, resulting in pulse stretching. When the dispersed spectral components propagate to the objective lens, the dispersed components are recombined to cancel out the phase mismatch, thereby compressing the pulse to its original width. As the phases of different spectral components are only re-matched at the focal plane, while the pulse remains stretched both before and after this plane, a temporally focused light sheet is generated at the focal plane.

United States Patent No. US 7,902,526 B2 discloses an imaging system that includes an optical pulse generator for providing an optical pulse having a spectral bandwidth and includes monochromatic waves having different wavelengths. A dispersive element receives a second optical pulse associated with the optical pulse and disperses the second optical pulse at different angles on the surface of the dispersive element depending on wavelength. One or more focal elements receives the dispersed second optical pulse produced on the dispersive element. The one or more focal element recombine the dispersed second optical pulse at a focal plane on a specimen where the width of the optical pulse is restored at the focal plane. While the said invention may have disclosed the use of a pulsed laser to produce either spatial or temporally focused light beam, eventually producing fluorescence 2D images, it is a conventional method to fabricate 2D/3D images with slower fabrication rate. In addition, mentioned art uses a fixed diffraction component (a grating) and an additional pattern generator to achieve the same temporal focusing projection effect described in United States Patent No. 10,207,365 B2 and No. 11,312,067.

United States Patent No. 20210354243A1 employs a DED-type shaping system which involves beam irradiation, material supply, movement systems wherein a DMD is also adapted to detect the state of each mirror element based on the intensity distribution of the reflection light. However, it is to note that DED-based processes are prone to distortion, high porosity and inhomogeneities with formation of 3D objects with low quality, low accuracy, and limited (tens of micrometer-level) resolution. Furthermore, it requires expensive materials and takes longer production time.

While 3D nanofabricating holds immense promise, it also presents challenges due to the incredibly small scales involved. Apart from costs, ensuring proper material properties, handling forces at the nanoscale, and developing precise control over the printing process are some of the challenges to be overcome.

### SUMMARY OF THE INVENTION

It is an objective of the present invention to provide a line-illumination temporal focusing 3D nano-fabrication apparatus and method for fabricating an object at a high throughput and controlled laser exposure level while maintaining high resolution based on line-illumination temporal focusing fabrication.

Another objective of the present invention is to eliminate the needs and errors from stitching due to the fabricating of large objects.

It is also an objective of the present invention to minimize nano-fabrication costs with a less bulky printing system with robust applications.

Accordingly, these objectives can be achieved by following the teachings of the present invention, which relates to a line-illumination temporal focusing three-dimensional (3D) nano-fabrication apparatus, the apparatus comprising: a laser source configured to emit a laser beam; a line-illumination pattern unit configured form a pre-determined line pattern from a line-shaped beam; a data acquisition unit configurable to receive input and transmit output signals for movement synchronization of multiple devices; an optical imaging device configured to monitor fabrication process in real time; a controller unit; and a substrate plane.

Additionally, the above objectives can be achieved the following a method of three-dimensional (3D) nano-fabricating using a line-illumination temporal focusing 3D nano-fabrication apparatus, the method comprising: (a) generating a series of line patterns from a 3D model; (b) configuring the 3D nano-fabrication apparatus by loading the generated series of line patterns into a memory of a dispersion device in the apparatus; (c) moving a substrate plane that is attached to a sample stage at the focal plane of an obj ective lens; (d) initiating fabrication process by a controller unit wherein a laser beam is emitted from a laser source, passing through an open shutter into a line-illumination unit while the sample stage and a dispersion device moves in synchronization of which is synchronized by a data acquisition unit and continuously move in synchronization in a parallel motion; and (e) completing the fabrication process and once completed, the sample stage returns to its original position, memory of the dispersion device (220) is cleared and the shutter is off.

### BRIEF DESCRIPTION OF THE DRAWINGS

The features of the invention will be more readily understood and appreciated from the following detailed description when read in conjunction with the accompanying drawings of preferred embodiments of the present invention, in which:
**FIG. 1** illustrates an overall view of a three-dimensional (3D) nano-fabrication apparatus;
**FIG. 2** illustrates an arrangement of a dispersion device;

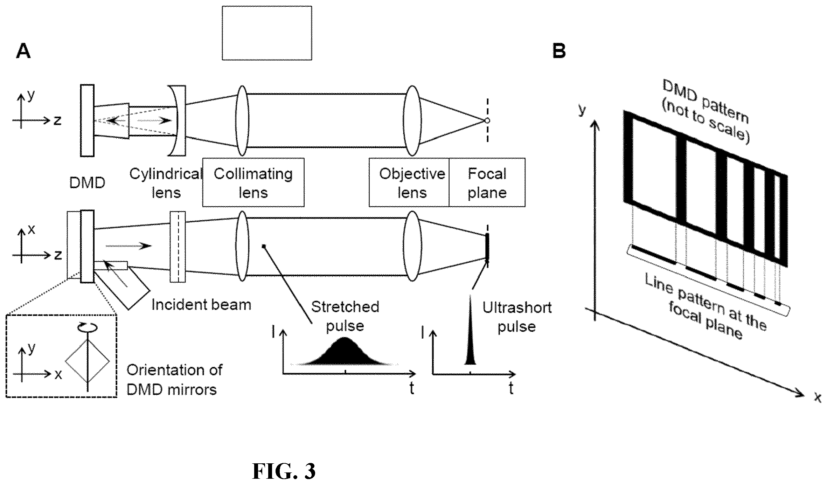

**FIG. 3** illustrates the principle of the line-illumination TF system: (A) y-z, x-z, and y-x views of the TF system. The rotational axis of the DMD mirrors is parallel to the y-axis, which induces dispersion in the x-z plane while keeping the beam non-modulated in the y-z plane. The fs laser beam is stretched in the time domain after the DMD and is then temporally (i.e., x-z plane) and spatially (i.e., y-z plane) focused into an intensity programmable-line at the focal plane of the objective lens; (B) spatially and temporally focused line pattern in the x-y plane and the corresponding DMD pattern;
**FIG. 4** illustrates grayscale control and correction of non-uniform illumination: (A) typical Gaussian laser beam profile; (B) beam profile in (A) cropped by the DMD aperture; (C, E, G) 2D DMD patterns with intensity pre-compensation to generate the designed line patterns in (D, F, H) respectively;
**FIG. 5** illustrates results of a line-illumination without and with grayscale control: (A) 2D DMD patterns without (top left) and with (top right) intensity pre-compensation; and the corresponding printing results (bottom); (B) measured profiles of the fabricated structures without (P1) and with (P2) intensity pre-compensation, where the P2 curve shows significantly improved uniformity; and,
**FIG. 6** illustrates the fabrication process using the 3D nano-fabrication apparatus.

### DETAILED DESCRIPTION

For the purposes of promoting and understanding the principles of the invention, reference will now be made to the embodiments illustrated in the drawings and described in the following written specification. It is understood that the present invention includes any alterations and modifications to the illustrated embodiments and includes further applications of the principles of the invention as would normally occur to one skilled in the art to which the invention pertains.

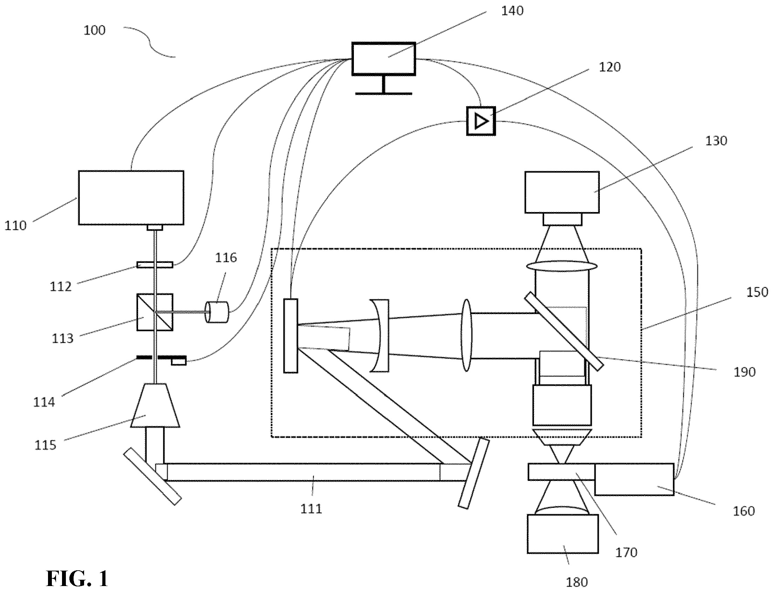

The present invention teaches a line-illumination temporal focusing three-dimensional (3D) nano-fabrication apparatus 100, the apparatus comprising: a laser source 110 emitting a laser beam 111; a line-illumination pattern unit 150 forming a pre-determined line pattern from a line-shaped beam; a data acquisition unit 120) receiving input and transmitting output signals for movement synchronization of multiple devices; an optical imaging device 130 configured to monitor fabrication process in real time; a controller unit 140; and a substrate plane 170. An overall view of the present invention is further illustrated in FIG. 1.

In one of the preferred embodiments of the present invention, wherein the multiple devices synchronized by the acquisition unit 120 are a sample stage 160 and the dispersion device 220 in the line-illumination pattern unit 150, wherein, the acquisition unit 120 receives input signals from the sample stage 160 and transmits output signals to the dispersion device 220 in the line-illumination pattern unit 150 for movement synchronization during fabrication process.

In one of the preferred embodiments, for a fabrication of a transparent object, an illumination light 180 is placed below a sample on the substrate plane 170 wherein an LED light is an example of the illumination light. The illumination light 180 is further reconfigurable to be epi-illuminated for an opaque or less transparent object. Other types of illumination lights may be applied, depending on the transparency of the object to be printed.

In another preferred embodiment, the optical imaging device 130 is a 2D imaging sensor selected from a group of complementary metal-oxide-semiconductor CMOS camera and a CCD camera. For example, a CMOS camera may be employed to monitor the fabrication process in situ, is built in conjunction with the fabrication system and placed at the conjugate plane of the objective lens's focal plane.

In another preferred embodiment of the present invention, the laser source 110 is a femtosecond fs laser. The fs laser has a workable center wavelength ranging from 400 nm - 2000 nm with a wide range of repetition rate i.e., 1kHz - 200 MHz, e.g. 800 nm with a repetition rate of 80 MHz, and a pulse width of <150 fs is used as the light source.

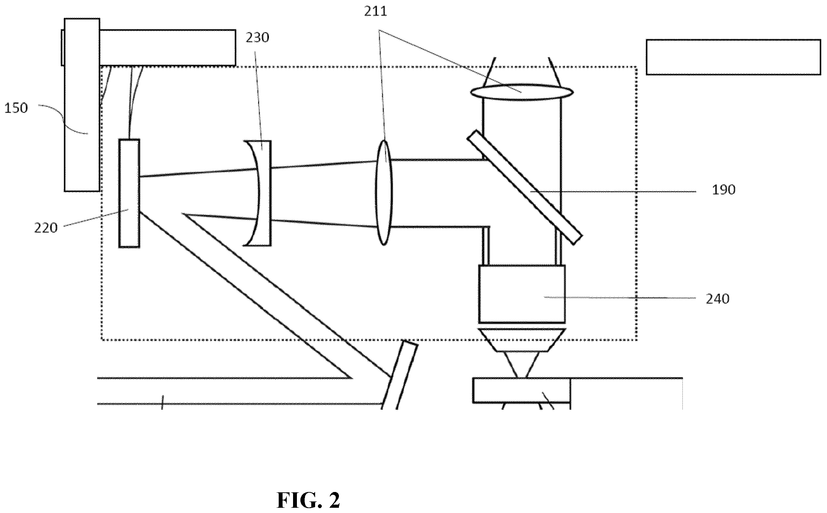

In one of the preferred embodiments, the line-illumination pattern unit 150 further comprises : a dispersion device 220 with a pre-determined intensity; a shaping lens 230 arranged in adjacent to the dispersion device 220, forming a line-shaped beam; and, a 4-f imaging system to relay the line-shaped beam and focus the laser beam onto a focal plane of an objective lens 240, forming the pre-determined line pattern on the substrate plane 170. More particularly, the laser beam is spatially focused on a Y-Z plane and temporally focused on an X-Z plane of the focal plane of the objective lens which together generates a 3D resolved intensity-programmable line. A close-up view of this embodiment is further illustrated in FIG. 2.

In another preferred embodiment, the shaping lens 230 is a cylindrical lens, and the 4-f imaging further comprises at least one collimator 211 and the objective lens 240.

In another preferred embodiment, the sample stage 160 is configured to move in X-Y-Z directions and is programmable by the control unit 140 to output trigger signals for the data acquisition unit 120 for movement synchronization during fabrication.

The data acquisition unit 120 may input trigger signals from the sample stage 160 and output switching signals to the dispersion device 220 for pattern switching. The data acquisition unit may also reprogrammable to input signals for arbitrary line structures.

In another preferred embodiment of the present invention, the controller unit 140 is a computer wherein the computer is configured to control laser source's power, shutter 114, the dispersion device's trigger mode, samples loading into the dispersion's memory, motion and trigger of the sample stage 160.

In order to produce spatially and temporally laser beam upon emission, the laser beam 111 may expand via a 2× - 20× beam expander 115 to fill aperture of the dispersion device 220. Further, the dispersion device 220 may be an array of micromirrors or digital micromirror device (DMD) wherein the beam is illuminated onto the DMD chip on the x-z plane and this is illustrated in the upper image of **FIG. 3A****.**

In another preferred embodiment wherein the laser beam 111 is dispersed by the dispersion device 220, entering the cylindrical lens (f = -100 mm) which is placed with a distance of its focal length, and the at least one collimator (f= 200 mm) 211, then reflected by a dichroic mirror 190, and lastly enters the objective lens (40X Oil, NA = 1.3) 240 to be spatially and temporally focused into the pre-determined line pattern.

More particularly, in the X-Z view, the fs laser may also be dispersed by the DMD, i.e., the spectral components are dispersed along the X-axis; as such, the pulses are widened. After the 4-f system, the dispersed laser spectral components are recombined and temporally focused at the focal plane of the objective lens into a line pattern, as illustrated in **FIG. 3B****.** Note that the intensity distribution along the line may be controlled by the pattern displayed on the DMD, and the length of each vertical stripe on the DMD determines the line intensity of each line segment, as illustrated in **Fig. 3B****.**

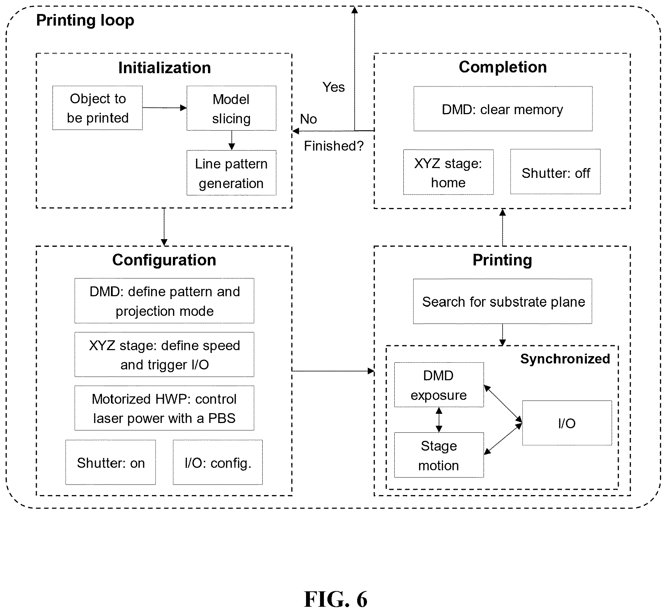

Another aspect of the present invention wherein the present invention also teaches a method 300 of three-dimensional 3D nano-fabricating using a line-illumination temporal focusing 3D nano-fabrication apparatus 100, the method comprising: (a) generating a series of line patterns from a 3D model; (b) configuring the 3D nano-fabrication apparatus 100 by loading the generated series of line patterns into a memory of a dispersion device 220 in the apparatus 100; (c) moving a substrate plane 170 that is attached to a sample stage 160 at the focal plane of an objective lens 240; (d) initiating fabrication process by a controller unit 140 wherein a laser beam 111 is emitted from a laser source 110, passing through an open shutter 114 into a line-illumination unit 150 while the sample stage 160 and a dispersion device 220 moves in synchronization of which is synchronized by a data acquisition unit 120 and continuously move in synchronization in a parallel motion; and (e) completing the fabrication process and once completed, the sample stage 160 returns to its original position, memory of the dispersion device 220 is cleared and the shutter 140 is off. This is further illustrated in FIG. 6.

In another preferred embodiment repeating steps (a) to (d) may be required in order to continue fabrication process until all structures are fabricated and once completed, the sample stage 160 returns to its original position, memory of the dispersion device is cleared and the shutter 140 is off.

In another preferred embodiment, the method of configuring the 3D nano-fabrication apparatus 100 from step (b) further comprising: defining line patterns and trigger mode of the dispersion device 220; defining speed of the sample stage 160 and outputting trigger signals for the data acquisition unit 120; determining laser power by a half wave plate (HWP) 112 and a polarization beam splitter 113; switching on the shutter 114; and configuring the data acquisition unit 120 to synchronize the sample stage 160 and the dispersion device 220 during the fabrication process.

In another preferred embodiment, adjusting line intensity of the sample in the dispersion device 220 and the sample stage 160 velocity could control laser illumination dose.

In a further preferred embodiment, the dispersion device 220 is an array of micromirrors or digital micromirror device (DMD) wherein each line pattern generated from step a further comprising any number of line segments having different grayscale intensities and lengths of which the number and length of the line segments is determined by the number and width of the vertical stripes on the DMD. The intensity of corresponding line segment is determined by the length of the vertical stripes on the DMD.

In another preferred embodiment of the present invention, wherein the laser beam 111 emitted from step (d) is reflected by a plurality of reflective mirrors then disperses via the DMD, then enters the concave cylindrical lens 230 and the at least one collimator 211, then is further reflected by a dichroic mirror 190, and lastly enters the objective lens 240 to be spatially and temporally focused into the pre-determined line pattern.

In another preferred embodiment of the present invention, the data acquisition unit 120 allows movement synchronization of multiple devices. For example, the data acquisition unit 120 receives input trigger signals from the sample stage 160 and transmit output switching signals to the DMD for pattern switching.

### EXAMPLES

### Throughput

To estimate the fabrication rate based on the present invention, the size of the DMD chip is 20.74 mm× 11.67 mm, which corresponds to a focal line length (*Lₗᵢₙₑ*) of 518.5 µm. (*Lₗᵢₙₑ = L_{DMD}*/*Mag =* (20.74 mm)/40 = 518.5 µm.) The stage has a speed of vₘₐₓ = 200 mm/s. By setting the layer height to 2 µm, the maximum printing rate is Tᵥₘₐₓ = 200 mm/s × 518.5 µm × 2 µm = 0.21 mm³/s = 747 mm³/hr.

In the event that a high-resolution structure is desired, the stage motion artifacts need to be considered, which may reduce the fabrication rate slightly. In the present invention, the DMD (V-9501) has a pattern rate of 18 kHz. To avoid motion errors, i.e., motion errors < PSF ≈ 300 nm, the speed of the stage should be limited to v = 300 nm × 18 kHz = 5.4 mm/s. In this case, the printing rate becomes Tᵥ = 5.4 mm/s × 518.5 µm × 2 µm = 5.6 × 10⁻³ mm³/s = 20.16 mm³/hr.

In both cases, the fabrication rate is comparable with existing inventions with a low-cost laser source, and 3 orders of magnitude higher than state-of-the-art commercial solutions.

### Uniformity and grayscale control

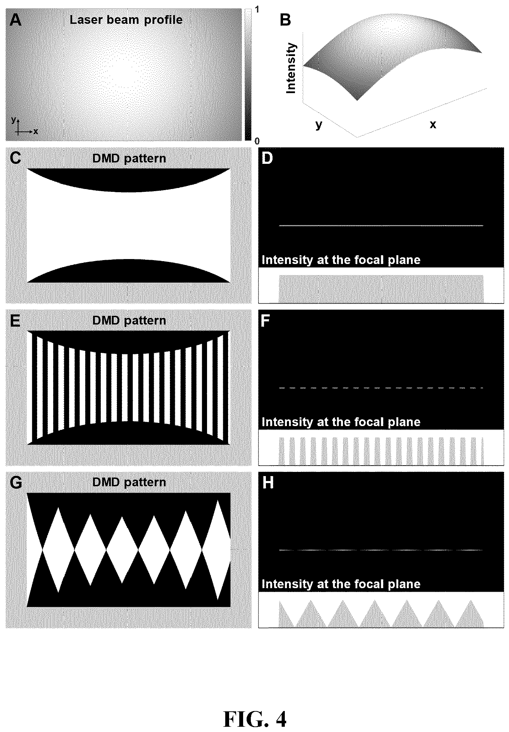

Light from a fs laser source has a Gaussian profile; and to achieve optimal fabrication results, the laser beam needs to be shaped into a flattop profile, which can be challenging and often results in a complex setup. Yet, this can be easily achieved in the present invention, i.e., by changing patterns displayed on the DMD (or length of each vertical strips in **FIG. 3B**), the intensity at each position on the line pattern can be precisely controlled, as illustrated in FIGS.4A-B.

FIGS. 4A-B show a typical 2D laser intensity (Gaussian) profile, which is non-uniform. Yet, this will not influence the precision of the present invention; and high resolution and highly uniform fabrication results can be directly achieved by slightly modifying the 2D DMD patterns. **FIGS. 4C** and **4E** present the intensity pre-compensated 2D DMD patterns, and **FIGS. 4D** and **4F** show the simulation results of the desired illumination line pattern, which are highly uniform.

To demonstrate precision of grayscale control using the Gaussian input beam, **FIGS. 4G** and **4H****,** respectively, present the designed intensity pre-compensated 2D DMD patterns and the simulated illumination line pattern, where precisely controlled gray scale illumination can be clearly observed in the sawtooth profile in the bottom of **FIG. 4H****.**

The precision of the grayscale control is on the level of 0.1%, which is determined by the number of pixels in the y-axis of the DMD.

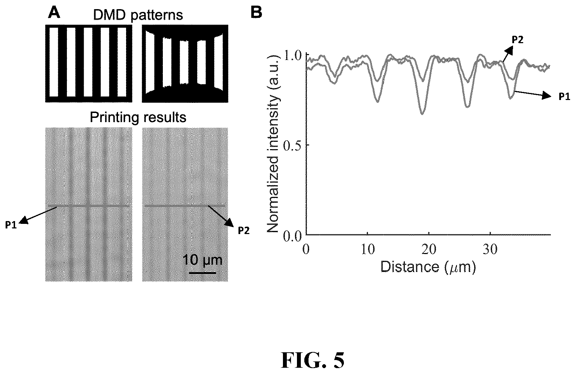

Analytical models were developed to verify the concept of the present invention wherein FIGS. 5A-B present the fabrication results of system without and with intensity pre-compensation. The light source has a Gaussian beam profile. From **FIG. 5B****,** one may observe clearly that uniformity of the fabricated strips have been significantly improved. The results were fabricated at a rate of 100 mm³/hr.

The present invention invention shows immense market potential in large-scale 3D nanofabrication, which has a broad range of applications in photonics, material design, biomedicine, and semiconductor. It will benefit both the scientific and industrial communities by providing a more capable 3D nano-printing platform in terms of speed, rate, cost, and flexibility. With over 3 orders of magnitude enhancement in the printing speed, this invention can reduce the cost for nanofabrication substantially. It also provides a robust and facile exposure strategy that can be used in different application scenarios, e.g., grayscale printing for tuning the refractive index of photonic devices. Uniform and large-scale complex 3D structures can be fabricated at scale, which promises the rapid prototyping and mass production of functional 3D nanostructures and devices, e.g., mechanical metamaterials and reconfigurable architectures.

The present invention explained above is not limited to the aforementioned embodiment and drawings, and it will be obvious to those having an ordinary skill in the art of the prevent invention that various replacements, deformations, and changes may be made without departing from the scope of the invention.

## Claims

1. A line-illumination temporal focusing three-dimensional (3D) nano-fabrication apparatus (100) comprising:
a laser source (110) configured to emit a laser beam (111);
a line-illumination pattern unit (150) configured to form a pre-determined line pattern from a line-shaped beam;
a data acquisition unit (120) configured to receive input and transmit output signals for movement synchronization of multiple devices;
an optical imaging device (130) configured to monitor fabrication process in real time;
a controller unit (140); and
a substrate plane (170).

2. The apparatus according to claim 1 wherein the multiple devices synchronized by the acquisition unit (120) are a sample stage (160) and a dispersion device (220) in the line-illumination pattern unit (150),
wherein, the acquisition unit (120) is configured to receive input signals from the sample stage (160) and transmit output signals to the dispersion device (220) in the line-illumination pattern unit (150) for movement synchronization during fabrication process.

3. The apparatus according to claim 1 or 2 wherein for a fabrication of a transparent object, an illumination light (180) is placed below a sample on the substrate plane (170).

4. The apparatus according to claim 3 wherein the illumination light (180) is reconfigurable to be epi-illuminated for an opaque or less transparent object.

5. The apparatus according to one of claims 1 to 4 wherein
the optical imaging device (130) is a 2D imaging sensor, selected from a group of complementary metal-oxide-semiconductor (CMOS) camera or a CCD camera; and/or
the laser source (110) is a femtosecond (fs) laser.

6. The apparatus according to one of claims 2 to 5, wherein, the line-illumination pattern unit (150) further comprises:
said dispersion device (220) with a pre-determined intensity;
a shaping lens (230) arranged adjacent to the dispersion device (220) for forming a line-shaped beam; and
a 4-f imaging system to relay the line-shaped beam and focus the laser beam (111) onto a focal plane of an objective lens (240), for forming the pre-determined line pattern on the substrate plane (170);
wherein, optionally, the shaping lens (230) is a concave cylindrical lens, and the 4-f imaging system further comprises at least one collimator (211) and the objective lens (240).

7. The apparatus according to one of claims 1 or 6, wherein the sample stage (160) is configured to move in X-Y-Z directions and is programmable by the control unit (140) to output trigger signals for the data acquisition unit (120) for synchronization during fabrication.

8. The apparatus according to one of claims 2 to 7, wherein the laser beam (111) is configured to expand via a beam expander (115) to fill aperture of the dispersion device (220).

9. The apparatus according to one of claims 1 to 8, wherein the data acquisition unit (120) is reprogrammable to input signals for arbitrary line structures.

10. The apparatus according to one of claims 2 to 8, wherein the controller unit (140) is configured to control the power of the laser source (110), a shutter (114), the trigger mode of the dispersion device (150), samples loading into a memory of the dispersion device (150), motion and trigger of the sample stage (160).

11. A method (300) of three-dimensional (3D) nano-fabricating using a line-illumination temporal focusing 3D nano-fabrication apparatus (100), preferably an apparatus according to any of claims 1 to 10, the method comprising:
(a) generating a series of line patterns from a 3D model;
(b) configuring the 3D nano-fabrication apparatus (100) by loading the generated series of line patterns in a memory of a dispersion device (220) in the apparatus (100);
(c) moving a substrate plane (170) that is attached to a sample stage (160) at the focal plane of an objective lens (240);
(d) initiating fabrication process by a controller unit (140) wherein a laser beam (111) is emitted from a laser source (110) and passes through an open shutter (114) into a line-illumination unit (150) while the sample stage (160) and the dispersion device (220) move in synchronization synchronized by a data acquisition unit (120) and continuously move in synchronization in a parallel motion; and
(e) completing the fabrication process and once completed, the sample stage (160) returns to its original position, memory of the dispersion device (220) is cleared and the shutter (114) is off.

12. The method according to claim 11, wherein further comprising:
the step (b) defining line patterns and trigger mode of the dispersion device (220);
the step (d) defining speed of the sample stage (160) and outputting trigger signals for the data acquisition unit (120);
determining laser power by a half wave plate (HWP) (112) and a polarization beam splitter (113);
switching on the shutter (114); and
configuring the data acquisition unit (120) to synchronize the sample stage (160) and the dispersion device (220) during the fabrication process.

13. The method according to claim 11 or 12, wherein adjusting line intensity of the sample in the dispersion device (220) and the sample stage (160) velocity controlling laser illumination dose.

14. The method according to one of claims 11 to 13, wherein the dispersion device (220) is an array of micromirrors or digital micromirror device (DMD).

15. The method according to claim 14, wherein
- each line pattern generated from step (a) further comprising any number of line segments having different grayscale intensities and lengths of which the number and length of the line segments is determined by the number and width of the vertical stripes on the DMD; and/or
- the intensity of corresponding line segment is determined by the length of the vertical stripes on the DMD; and/or
- the laser beam (111) emitted from step (d) is reflected by a plurality of reflective mirrors then disperses via the DMD, then enters the concave cylindrical lens and the at least one collimator (211), then is further reflected by a dichroic mirror (190), and lastly enters the objective lens (240) to be spatially and temporally focused into the pre-determined line pattern; and/or
- the data acquisition unit (120) inputs trigger signals from the sample stage (160) and outputs switching signals to the DMD for pattern switching.
